# EUROPEAN PATENT APPLICATION

(11) **EP 2 020 687 A1**
(43) Date of publication of application: **04.02.2009**
(21) Application number: 06741965.5
(22) Date of filing: 24.05.2006
(51) Int. Cl.: H01L 31/0224, H01L 31/042, C25D 19/00

(54) **METHOD FOR MANUFACTURING ELECTRODES OF SOLAR CELL AND ELECTROCHEMICAL DEPOSITING APPARATUS**

(30) Priority: 20.04.2006 CN 200610076375
(71) Applicant: Wuxi Suntech Power Co. Ltd., New District, Wuxi Jiangsu 214-028 (CN)
(72) Inventor: JI, Jingjia, Wuxi, Jiangsu 214028 (CN); SHI, Zhengrong, Wuxi, Jiangsu 214028 (CN); QIN, Yusen, Wuxi, Jiangsu 214028 (CN); WENHAM, Stuart, Wuxi, Jiangsu 214028 (CN); ARTES, Granham, Wuxi, Jiangsu 214028 (CN)
(74) Representative: Grünecker, Kinkeldey, Stockmair & Schwanhäusser Anwaltssozietät
(86) International application number: PCT/CN2006/001077
(87) International publication number: WO 2007/121619

(57) **Abstract**

A method for manufacturing electrodes of solar cell and electrochemical depositing apparatus are disclosed. The method for manufacturing electrodes of solar cell is a method using the process of electrochemical depositing metal or metal alloy to form electrodes of solar cell. The method of the present invention can improve photoelectric conversion efficiency and reduce the production cost. The reaction time of the method is short and industrial waste liquid is treated easily.

## Description

### Field of the Invention

The present invention relates to a method for manufacturing electrodes of solar cell and electrochemical depositing apparatus. More specifically, the present invention relates to a method for manufacturing electrodes of solar cell and electrochemical depositing apparatus, which can improve photoelectric conversion efficiency and reduce the production cost. The reaction time of the method is short and the industrial waste liquid produced can be treated easily.

### Background of the Invention

Solar cell is an apparatus that can convert the light energy into electric energy. Generally, the solar cell may include film solar cell and semiconductor slice solar cell such as the crystalline silicon solar cell in the semiconductor slice solar cell may include monocrystalline silicon solar cell and polycrystalline silicon solar cell. The conversion efficiency of solar cell for converting the energy of sunlight into electric energy is an important performance for the solar cell. Because the purity and the quality of crystal of monocrystalline silicon are higher than those of polycrystalline silicon, the efficiency of monocrystalline silicon solar cell is generally higher than that of polycrystalline silicon solar cell.

The production process of massive industrialization of crystalline silicon solar cell generally is that, firstly, a damage layer of the surface of the crystalline silicon is removed, then a process of texturing is performed to reduce the reflectivity of the surface of the crystalline silicon, and then the diffusion is made to form a PN Junction, and a silicon nitride film is deposited on the surface of emitter of solar cell for passivating and antireflection, finally, metal electrodes are printed by screen printing, after the sintering process for the positive electrode and the negative electrode, the solar cell is formed. The efficiency of the solar cell obtained by present method using screen printing process to form the electrodes of solar cell is around 14-16%.

Although the method using screen printing to form electrodes of solar cell is easy for production, for obtaining better ohmic contact of the electrodes of solar cell and the crystalline silicon and reducing the contact resistance, the shadow area of the electrode screen printed is relatively large, which is generally around 5%, and the emitter sheet resistance of the electrode screen printed is relatively small, which is around 50Ω. Such design of solar cell is one of the reasons why the conversion efficiency of the present commercial solar cell is low.

In order to reduce of the shadow area of solar cell and improve the emitter resistance, S. Wenhem invented a structure of solar cell which is referred to as the buried contact cell twenty years ago. The said structure of the solar cell is developed aiming at the disadvantages of the process of the conventional screen printing. In the design of the structure of the buried contact cell, a plane contact electrode is replaced with a groove contact electrode in order to reduce the shadow area. Such design of the structure not only ensures the contact area of the electrodes and the solar cell, but also reduces the width of each electrode from 150µm to 30µm, furthermore, it reduces the shadow area of the electrodes of solar cell from 5% which is conventional to 3% below.

Meanwhile, the structure of the buried contact cell makes it possible to manufacture the selective-diffusion solar cell. In the design of the buried contact cell, the emitter sheet resistance is generally controlled to be above 100Ω, while the sheet resistance in the groove is controlled to be 10Ω below. After the emitter sheet resistance being improved, the current in the solar cell will greatly increase, and therefore, the photoelectric conversion efficiency of solar cell is improved. The efficiency of the buried contact cell massively produced is generally above 17.5%.

The present electrode of the buried contact cell massively produced is manufactured by a method for chemical depositing copper. The process of chemical depositing copper is a relatively slow chemical process, which generally needs approximately 10 hours to obtain a required thickness of copper electrodes. In order to prevent the stress and the adsorption problem caused by the excessively rapid depositing rate, the rate for depositing copper is generally controlled at 2µm per hour below. Another reason for controlling the rate for depositing copper at a relatively small rate is to prevent the close over at the upper of the groove caused by the copper during depositing process.

Another problem of manufacturing the electrodes of the buried contact cell by using the method for chemical depositing copper is that the service life of the solution of chemical depositing copper is short, wherein the solution cannot be used any more after being used for several batches. Accordingly, a great amount of waste liquid is discharged when the method of chemical depositing copper is used in massive production. Because the organics that is difficult for process are contained in the discharged waste liquid, the process using chemical depositing copper increases the production cost.

Additionally, the solution of chemical depositing copper is relatively unstable, and the self-precipitation of copper easily occurred, which influences the normal production. In addition, the condition control of the process of chemical depositing copper is also very strict. For example, the requirement of the temperature control for the solution of chemical depositing copper is very strict. To reduce the possibility of self-precipitation of copper, not only air bubbling but also filtration is required during the process of chemical depositing copper. For maintaining the stability of the solution concentration, adding the supplementary solution is also required. The adding of the supplementary solution must be controlled strictly. If the supplementary solution is too much added, then the self-precipitation of copper may occur, while if the supplementary solution is excessively less added, then the rate of depositing copper may be reduced.

In addition, most of the operations processes for chemical depositing copper are performed at a temperature which is higher than the room temperature, for example, higher than 50 degree, and thus a great amount of energy supply is required for such a process, and the production cost is further increased. Due to the long period of the reaction time, the energy consumption is quite considerable.

The problem that how to overcome the disadvantages of the conventional technology described above while improving the photoelectric conversion efficiency needs to be overcome urgently.

### Summary of the Invention

The present invention is provided for the problems described above. One aspect of the present invention is to provide a method for manufacturing electrodes of solar cell and its electrochemical depositing apparatus, which can not only improve the ohmic contact between the electrodes of solar cell and the crystalline silicon, but also increase the adsorption force of the electrodes of solar cell and the crystalline silicon, reduce the series resistance of solar cell and improve the conversion efficiency of the solar cell;

Another aspect of the present invention is to provide an electrochemical depositing method and its apparatus for manufacturing electrodes of solar cell, which is applied for manufacturing the electrodes of the buried contact cell, and this method can significantly reduce the time and the manufacturing cost of forming the electrodes and improve the production efficiency;

Another aspect of the present invention is to provide a method for manufacturing electrodes of solar cell and electrochemical depositing apparatus, which can greatly reduce the cost for manufacturing electrodes of the buried contact cell;

A further aspect of the present invention is to provide a method for manufacturing electrodes of solar cell and apparatus thereof which can reduce the discharge amount of waste liquid in production. The waste liquid generated according to the method is easily to be treated, and thus the method is an environmental protection method for manufacturing electrodes of solar cell.

In order to achieve the objects described above and to obtain the advantages described above, the present invention provides a method for manufacturing electrodes of solar cell, comprising: a step of performing a shallowly diffusion on one surface of a semiconductor slice to form a PN Junction after the surfaces of the semiconductor slice cleaned and textured; a step of depositing a film for passivation and antireflection on the shallowly diffused surface of the semiconductor slice; a step of forming grooves on the said surface of the semiconductor slice; a step of performing a deep diffusion after the grooves are cleaned; a step of performing a passivation process for the surface which is opposite to the said surface of the semiconductor slice; a step of performing a chemical depositing metal process for the passivated semiconductor slice, and forming an alloy of the semiconductor slice and the metal after their sintering; a step of performing chemical depositing metal or metal alloy for the semiconductor slice described above for a predetermined time; a step of performing electrochemical depositing metal or metal alloy for the semiconductor slice in an electrochemical depositing apparatus, to form the electrodes of solar cell.

The present invention further provides a method of manufacturing the electrodes of solar cell, comprising: a step of performing a shallowly diffusion on one surface of a semiconductor slice to form a PN Junction after surfaces of the semiconductor slice are cleaned and textured; a step of depositing a layer of film for passivation and antireflection on the shallowly diffused surface of the semiconductor slice; a step of eliminating the passivation and antireflection film at the located portion where main gratings and auxiliary gratings located on the said surface of the semiconductor slice; a step of washing the located portion of the main gratings and the auxiliary gratings and then performing a deep diffusion; a step of performing a passivation process for the surface which is opposite to the said surface of the semiconductor slice; a step of performing a chemical depositing metal process for the passivated semiconductor slice, and forming an alloy of the semiconductor slice and the metal after their sintering; and a step of performing electrochemical depositing metal or metal alloy for the semiconductor slice in an electrochemical depositing apparatus, to form the electrodes of solar cell.

The present invention further provides an electrochemical depositing apparatus for manufacturing the electrodes of solar cell, wherein, regarding the method of manufacturing the electrodes of solar cell, the apparatus is used in the step of performing electrochemical depositing metal or metal alloy to form the electrodes of solar cell, and the apparatus includes: an electrolytic solution cell where the electrolytic solution is contained; at least one of the electrodes of metal or metal alloy in the electrolytic solution; a power supply unit for outputting the electric energy; and a semiconductor slice disposed parallel to the electrodes of metal or metal alloy.

Differ with the principle of the conventional chemical metallization, the process of formation of electrodes of the present invention is an electrochemical process, that is, the formation of metal electrodes is driven by electric energy. The metal ions in electrolytic solution driven by the electric potential are made to move to the negative electrode and the electrons captured on the surfaces of the negative electrode, i.e., the surface of the semiconductor slice to generate the metal atoms. With the driven of the electric potential, the metal at the positive electrode loses electrons continuously and forms metal ions, which are dissolved continuously in the electrolytic solution to maintain the stability of the concentration of the metal ions in the electrolytic solution.

Owing to the fact that the principle of chemical depositing metal and that of electrochemical depositing metal are fundamentally different, the rate of formation of the electrodes of the invention, namely, the rate of depositing metal is much faster than the rate of chemical depositing metal. An important advantage of the present invention is that the time of formation of the electrodes is decreased from approximately 10 hours for chemical depositing metal to within an hour. Generally, the formation of the electrodes may be completed in more than 10 minutes.

Another advantage of the present invention is that because the process of electrochemical depositing metal is simpler than that of chemical depositing metal, the scope of operation is wider, and thus electrochemical depositing metal is particularly appropriate for industrial production. For example, the temperature required by electrochemical depositing metal is not high, and electrochemical depositing metal may be generally operated at room temperature, thus, it is not only convenient for control of production, but also saves the heating cost. The composition of the electrolytic solution used in the process of electrochemical depositing is also very simple, and accordingly, the electrolytic solution may be used repeatedly for a long time.

The metal electrodes formed in a general process of chemical depositing are not crystalline, while the metal electrodes of electrochemical depositing are crystallitic, accordingly, the metal electrodes formed by electrochemically deposited have better stability and conductivity, which directly influences that the metal electrodes of electrochemical depositing can reduce the loss of current produced by the solar cell on the electrodes and improve the conversion efficiency of solar cell.

Because the chemical reaction of electrochemical depositing metal is very simple, for example, influences of electrochemical depositing metal on PH value of electrolytic solution and change in the composition of the solution are very little, and the management of the solution is also very simple, the process of electrochemical depositing of the present invention is appropriate for industrial production. More importantly, the manufacture cost for the method in formation of the electrodes of solar cell of the present invention is very low. And the treatment for waste liquid is simpler than chemical depositing metal. For the solar cell produced by the electrochemical process according to the present invention, there is little waste liquid, and the treatment of waste liquid is easy to be made.

### Brief Description of the Drawings

FIG. 1 is the view schematically illustrating the electrochemical depositing apparatus for manufacturing electrodes of solar cell according to the present invention.
FIG 2 is the view schematically illustrating the structure of the buried contact solar cell which is manufactured according to the present invention.

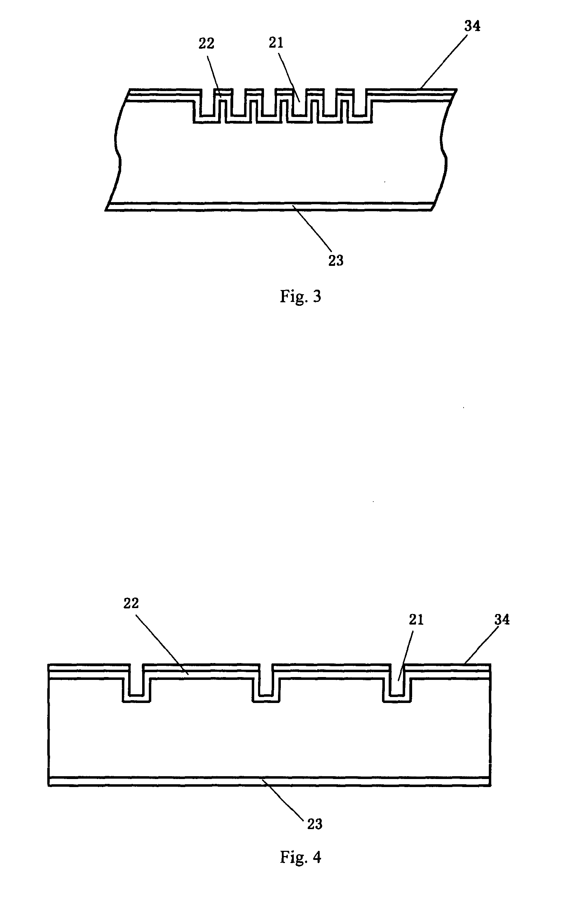

FIG. 3 is the cross-sectional view illustrating the structure of main gratings of the buried contact cell in the first embodiment before the electrochemical depositing metal or metal alloy.
FIG. 4 is the cross-sectional view illustrating the structure of auxiliary gratings of the buried contact cell in the first embodiment before the electrochemical depositing metal or metal alloy.

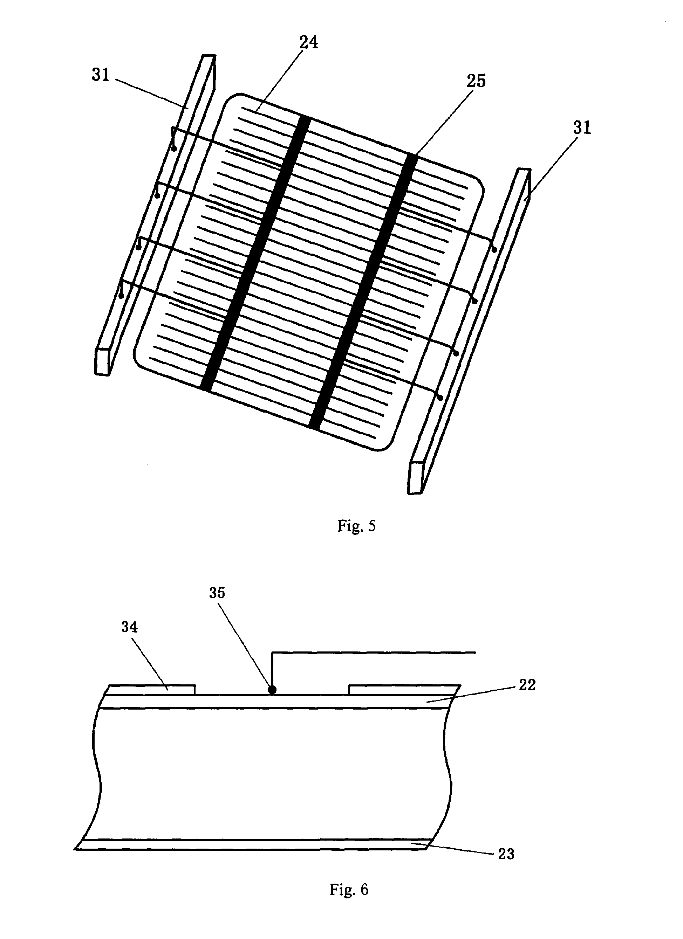

FIG. 5 is the view schematically illustrating the process of multi-point contact for the conventional solar cell in the second embodiment of the present invention.
FIG. 6 is the cross-sectional view illustrating the process of multi-point contact for main gratings in the second embodiment.

### Denotation of accompanying Drawings

- 10: electrolytic solution
- 11: electrodes of metal or metal alloy
- 12: semiconductor slice
- 13: electrolytic bath
- 14: power supply unit
- 15: conducting wire
- 16: conducting wire
- 17: switch
- 21: laser groove
- 22: emitter
- 23: back electrode
- 24: auxiliary gratings
- 25: main gratings
- 26: solar cell
- 31: negative electrode of power
- 34: antireflection film
- 35: contact

### Detailed Description on the Example Embodiments

The method for manufacturing electrodes of solar cell and apparatus thereof according to the present invention will be described with reference to accompanying drawings in detail.

### The first embodiment

Shallowly diffusion is performed to a 125*125 mm sheet of monocrystalline silicon after it being washed and textured; the sheet resistance of the emitter 22 shallowly diffused is controlled to 150Ω; a layer of silicon nitride is deposited on the surface of the emitter 22 as passivation and antireflection film 34. Grooves 21 are fluted on the surface of the emitter 22 by the laser to form main gratings 25 and auxiliary gratings 24 crossing each other; a deep diffusion is performed to the main gratings 25 and auxiliary gratings 24 after they are washed so that the sheet resistances of the main gratings 25 and auxiliary gratings 24 achieve to 10Ω below; aluminum is sputtered on the back of the emitter 22 and sintered to form an aluminum back surface field i.e., back electrode 23; a chemical depositing nickel treatment is made to the silicon sheet on which the aluminum back surface field is formed after the said silicon sheet is rinsed by hydrofluoric acid, after which is sintering to form the silicon and nickel alloy; chemical depositing metal or metal alloy is performed to the silicon and nickel alloy for about 15 minutes so that the resistances of the auxiliary gratings are 3Ω per centimeter; and an electrochemical deposition treatment is made to the silicon sheet to form electrodes of solar cell.

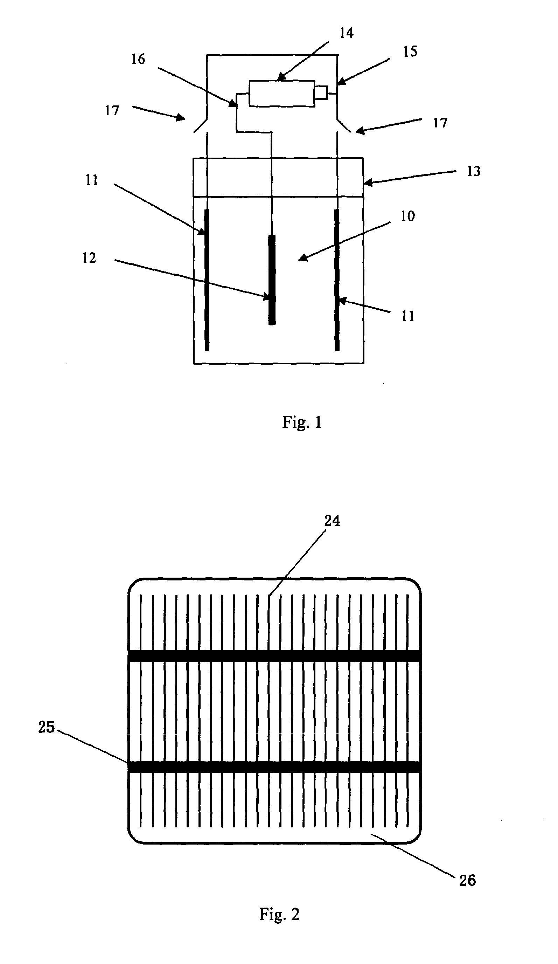

The electrochemical depositing apparatus, in which the silicon is electrochemically deposited, as shown in Fig. 1, includes an electrolytic bath 13, electrolytic solution 10, electrodes of metal or metal alloy 11, a power supply unit 14 and a semiconductor slice 12.

The semiconductor slice 12 in the embodiment is a silicon sheet.

The electrodes of metal or metal alloy 11 are generally plate or other physical shapes, such as shape of net. In order to achieve better distribution of electric field, the area of the electrodes of metal or metal alloy 11 is generally larger than the semiconductor slice 12. Generally, two electrodes of metal or metal alloy should be parallel with each other, thus, the relatively uniform distribution of electric field is obtained to achieve the uniformity of metal deposited. The electrodes of metal or metal alloy 11 on both sides are selectively connected by a conducting wire 15 through switches 17.

The semiconductor slice 12 is disposed between the two electrodes of metal or metal alloy 11 and to be paralleled with the above two electrodes. Conducting wire 16 connects the negative electrode of power supply unit 14 and the semiconductor slice 12. The conducting wire 15 connects the positive electrode of the power supply unit 14 and electrodes of metal or metal alloy 11 through the switches 17. Under the condition that the switches 17 are both closed, both surfaces of the semiconductor slice 12 and the electrodes of metal or metal alloys 11 produce a difference of electric potential at the same time when the power supply unit 14 is outputting electric energy, and in the function of the above difference of electric potential the metal ions in the electrolytic solution 10 continuously deposits on the semiconductor slice 12, while the metal on the electrodes of metal or metal alloys 11 is continuously ionized in the electrolytic solution 10, and thus, the solar cell with the electrodes being formed on both surfaces of the semiconductor slice 12 at the same time is obtained.

Generally, the metal or metal alloy may be a copper, silver, or other metal or metal alloy conducting materials of metal or metal alloy which can be achieved by ohmic contact with the semiconductor slice.

The power supply unit 14 in Fig. 1 may be a direct current (DC) power, or a pulse power. The rate of electrochemical depositing is more rapid than the rate of the pulse power with the same current concentration when the direct current power is used. Of course, the pulse power may also be used, and the advantage of using the pulse power is that the electrodes deposited are relatively smooth and flat, the depositing rate is relatively slow however. Of course, for the buried contact cell, the advantage of the pulse power is that it can avoid the close over of metal or metal alloy at the upper of the laser groove and the space under the laser groove. Of course, if the electrodes of solar cell do not deposit in the laser groove, the relatively great effect may be achieved by using the direct current power.

The electrolytic solution 10 may be a usual metallic salt solution, for example, a bluestone solution. The advantage of using the bluestone solution is that its chemical composition is very simple and the production cost is very low. Of course, a little additive is very helpful for improving the planeness of depositing metal electrodes sometimes.

The electrolytic bath 13 is generally manufactured by macromolecule polymer as the material. Because the electrolytic solution 10 is generally a weak acid, the macromolecule polymer such as plastics and etc. may be used as the material of electrolytic bath.

The current concentration for the electrodes of the electrochemically deposited metal of the present invention may change depending on various metals. For example, the current concentration may be controlled to a value between 1 and 5 ampere per square decimeter when the metal is a copper. As the current concentration increases, the rate of electrochemical depositing metal increases. When the current concentration is too low, the depositing rate of metal becomes very slow. When the current concentration is too high, there is a relatively great stress in the metal film deposited, therefore, the difference of adsorption is caused. Meanwhile, the current concentration of metal electrodes also depends on the structure of solar cell. For example, during the formation of electrodes on the buried contact cell as shown in Fig. 2, the rate of depositing metal which is too rapid may cause the close over at the upper of the laser groove, and the space under the laser groove.

The temperature for electrochemical depositing metal by the present apparatus may be modified depending on various metals. For example, when the metal is a copper, the depositing temperature may be controlled simply at the room temperature. If the temperature for depositing metal is too low, not only the rate of depositing copper is influenced, but also the depositing process will not occur. If the temperature for depositing metal is too high, not only the energy cost is influenced, but the degree of roughness is increased by a great amount.

The time for electrochemical depositing metal is generally controlled between 3 minutes and 1 hour by the apparatus. The preferable time for electrochemical depositing metal depends on the surface state of solar cell, the current concentration for electrochemical depositing metal and the temperature for electrochemical depositing metal. If the electrodes of solar cell are in the groove, in order to prevent the upper port of the groove from capping, the rate of electrochemical depositing may be slightly slow, which may be controlled between 10 minutes and 1 hour.

The power supply unit 14 is selected as the pulse power, and the copper is selected as the electrodes of metal or metal alloy in the embodiment, and the specific method for the electrochemical depositing process for a silicon sheet by the unit described above is that the negative electrode of the pulse power is connected to the two end portions of the main gratings and disposed in the electrolytic bath 13, in which the electrolytic solution 10 is the bluestone solution, and the two sides of the silicon sheet is a copper board connected to the positive electrode of the pulse power, and the current concentration is controlled at 2.5 ampere per square decimeter; the temperature of the electrolytic solution cell is 25 degree, electrochemical depositing for 20 minutes, a solar cell is formed after being washed and dried. It is determinate that the photoelectric conversion efficiency of the solar cell is 18.08%, wherein, the current concentration of the solar cell, the voltage and the filling factor is 37.16mA/cm², 616 mV and 0.795, respectively.

### The second embodiment

Diffusion is performed to a 125*125 mm sheet of polycrystalline silicon to form a PN Junction after the damage layer of the sheet of polycrystalline silicon is washed; the sheet resistance after diffused is 100Ω. Then a film of silicon nitride is deposited on the surface of the emitter of the polycrystalline silicon for passivation and antireflection. The silicon nitride at the main grating 25 and auxiliary gratings 24 is eroded to clean by using the method of chemical erosion, and then the deep diffusion is performed so that the sheet resistance at the grating part is below 10Ω. Aluminum is screen printed on the back of the emitter 22 and sintered to form an aluminum back surface field i.e., back electrode 23. Then depositing a layer of thin film of nickel by dipping the polycrystalline silicon in the solution in which nickel is chemical deposited, a nickel alloy is formed after sintering, then a electrochemical deposition treatment is made to the polycrystalline silicon sheet by use of the electrochemical depositing apparatus described above to form the electrodes of solar cell.

In the electrochemical depositing apparatus described above, the positive electrode of the power supply unit 14 may be connected to any side of the electrodes of metal or metal alloy 11 via the switch 17. Thus, the process of forming the electrodes by electrochemical depositing can only occurs on one surface of the semiconductor slice 12. For example, when the process of manufacturing solar cell only requires that the metal is deposited on the emitter electrode of solar cell, the metal electrode faced to the emitter is only electrified to positive in the present invention, thus the electrodes of solar cell are only formed on the emitter.

In addition, the number of the contacts of the negative electrode of the power supply unit 14 and the semiconductor slice 12 may change according to various structures and processes of solar cell. For example, when the resistance of the main gratings and auxiliary gratings of the semiconductor slice 12 is high, the method of multi-points contact may be used.

Because the electrodes of solar cell are deposited on a plane, greater current concentration may be used, that is, the electrochemical depositing metal may be made faster, and thus, the time for depositing the electrodes of solar cell may be controlled in 5 to 15 minutes.

In the embodiment, preferably, a direct current power is selected as the power supply unit 14, and copper is selected as the electrodes of metal or metal alloy, the process for electrochemical depositing for the polycrystalline silicon sheet specifically is that: the negative electrode of the direct current power may be connected to the main grating of the polycrystalline silicon sheet by using the method of multi-point contact, and the distance between any two contacts 35 is 10 mm; the polycrystalline silicon sheet is disposed in the electrolytic bath 13 in which the electrolytic solution 10 is the bluestone solution, and the copper board faced to the emitter is connected with the positive electrode of the direct power apparatus; the control for current concentration is at 3.5 ampere per square decimeter; the temperature of the electrolytic bath is controlled at 25 degree, and electrochemical depositing for 15 min, a solar cell is formed after being washed and dried. It is determined that the conversion efficiency of solar cell is 15.87%, wherein, the current concentration of the solar cell, the voltage and the filling factor is 33.37mA/cm², 619mV and 0.769, respectively.

### The third embodiment

It is proved that the photoelectric conversion efficiency of solar cell achieved by depositing a layer of metal on the main gratings and auxiliary gratings of the emitter by using the method of chemical depositing metal firstly to reduce the resistance of the gratings, and then electrochemical depositing.

Specifically, after forming the silicon and nickel alloy by sintering the silicon sheet with the aluminum back surface field of the second embodiment, after chemical depositing copper for about 15 min, the resistance of the auxiliary gratings are at 1Ω per centimeter, then the negative electrode of the pulse power is connected to one side of the main grating and disposed in the electrolytic bath 13, in which the electrolytic solution 10 is the bluestone solution, and the two sides of the silicon sheet are the copper board which connected to the positive electrode of the pulse power, and the current concentration is controlled at 2.5 ampere per decimeter; the temperature of the electrolytic bath is 25 degree, electrochemical depositing for 20 min, the electrodes of solar cell are formed after being washed and dried. It is determined that the photoelectric conversion efficiency of solar cell is 16.12%, wherein, the current concentration of the solar cell, the voltage and the filling factor is 33.98mA/cm², 615mV and 0.772, respectively.

In the method described above, if the method of multi-point contact is used, as the thickness of chemically deposited metal continuously increases, the contacts of the negative electrode of the power supply unit 14 and the semiconductor slice 12 may decreases gradually. When the thickness of the metal chemically deposited achieves to a certain thickness, manufacturing of electrodes of solar cell of the present invention may be achieved with a contact between the negative electrode of the power supply unit 14 and the semiconductor slice 12.

The present invention is not specifically restricted to the embodiments described above, and various changes and modifications may be made by the skilled in the art without departing from the spirit and nature of the present invention. These corresponding changes and modifications both belong to the protecting range of the claims enclosed by the present invention.

## Claims

1. A method for manufacturing electrodes of solar cell, **characterized by** comprising:
a: a step of performing a shallowly diffusion on one surface of a semiconductor slice to form a PN Junction after surfaces of the semiconductor slice are washed and textured;
b: a step of depositing a layer of film for passivation and antireflection on the shallowly diffused surface of the semiconductor slice;
c: a step of forming grooves on the said surface of the semiconductor slice;
d: a step of performing a deep diffusion after the grooves are washed;
e: a step of performing a passivation process for the surface which is opposite to the said surface of the semiconductor slice;
f: a step of performing a chemical depositing metal process for the passivated semiconductor slice, and forming an alloy of the semiconductor slice and the metal after their sintering;
g: a step of performing chemical depositing metal or metal alloy for the semiconductor slice described above for a predetermined time; and
h: a step of performing electrochemical depositing metal or metal alloy for the semiconductor slice in an electrochemical depositing apparatus, to form the electrodes of the solar cell.

2. The method according to claim 1, wherein,
the semiconductor slice is a sheet of monocrystalline silicon or polycrystalline silicon.

3. The method according to claim 1, wherein,
the metal or metal alloy may be a copper, silver, or other conducting materials of metal or metal alloy which can ohmic contact with the semiconductor slice.

4. The method according to claim 1, wherein,
in step b, silicon nitride is used as the film for passivation and antireflection, and the metal in step f is nickel.

5. The method according to claim 1, wherein,
the grooves in step c and d are main gratings and auxiliary gratings crossing each other formed by using the method of laser lithography or chemical erosion.

6. The method according to claim 1, wherein,
in step e, the silicon and aluminum alloy may be obtained by using sputtering aluminum on another surface of the semiconductor slice or printing screen aluminum plasm and sintering.

7. The method according to claim 5, wherein, step h further includes:
the positive electrode of the power supply unit is connected with the electrodes of metal or metal alloy contacted with the electrolytic solution in the electrochemical depositing apparatus;
the semiconductor slice is disposed in the electrolytic solution; and
the negative electrode of the power supply unit is connected with the main grating of the semiconductor slice.

8. The method according to claim 7, wherein,
the electrolytic solution is an electrolytic solution with the ions of the metal or metal alloy which the molecule structure is same as that of the said metal or metal alloy.

9. The method according to claim 7, wherein,
the power supply unit may be a direct current power or a pulse power.

10. The method according to claim 7, wherein,
the manner of connecting the negative electrode of the power supply unit with the main grating may be the manner of connecting one or two sides of the main grating, or the connecting manner in which there are multi contacts with uniform space between the negative electrode of the power supply unit and the main grating.

11. The method according to claim 7, wherein,
the electrodes may be formed on both surfaces of the semiconductor slice simultaneously, or only on any surface of the semiconductor slice according to the number of the electrodes of metal or metal alloys and the specific position in which the potential field is formed corresponding to the semiconductor slice.

12. A method for manufacturing electrodes of solar cell, **characterized by** comprising:
a: a step of performing a shallowly diffusion on one surface of a semiconductor slice to form a PN Junction after surfaces of the semiconductor slice are washed and textured;
b: a step of depositing a layer of film for passivation and antireflection on the shallowly diffused surface of the semiconductor slice;
c: a step of eliminating the passivation and antireflection film at the portion where a main grating and an auxiliary gratings located on the surface of the semiconductor slice;
d: a step of washing the main gratings and the auxiliary gratings and then performing a deep diffusion;
e: a step of performing a passivation process for the surface which is opposite to the surface of the semiconductor slice;
f: a step of performing a chemical depositing metal process for the passivated semiconductor slice, and forming an alloy of the semiconductor slice and the metal after their sintering; and
g: a step of performing electrochemical depositing metal or metal alloy for the semiconductor slice in an electrochemical depositing apparatus, to form the electrodes of the solar cell.

13. An electrochemical depositing apparatus for manufacturing electrodes of solar cell, wherein,
the apparatus is used in the step in which the method of manufacturing the electrodes of solar cell is used according to any one of the claims 1-12 for electrochemical depositing metal or metal alloy to form the electrodes of solar cell, and the apparatus comprising: an electrolytic bath in which the electrolytic solution is contained; at least one electrode of metal or metal alloy being disposed in the electrolytic solution; a power supply unit for outputting electric energy; and a semiconductor slice being disposed parallel to the electrodes of metal or metal alloys.

14. The electrochemical depositing apparatus according to claim 13,
**characterized in that**,
the positive electrode of the power supply unit may be selectively connected with the electrodes of the metal or metal alloy via the switch.

15. The electrochemical depositing apparatus according to claim 13 or 14,
**characterized in that**,
the power supply unit is a direct current power or a pulse power.

16. The electrochemical depositing apparatus according to claim 13 or 14,
**characterized in that**,
the negative electrode of the power supply unit may be connected with the semiconductor slice by using a manner of multi-point contact.
